# EUROPÄISCHE PATENTSCHRIFT

(11) **EP 3 834 257 B1**
(45) Veröffentlichungstag und Bekanntmachung des Hinweises auf die Patenterteilung: **21.06.2023**
(21) Anmeldenummer: 19758598.7
(22) Anmeldetag: 06.08.2019
(51) Int. Cl.: H01R 12/61, H01R 4/04, H01R 43/00, A41D 1/00, H05K 1/03

(54) **VERFAHREN ZUM HERSTELLEN EINES ELEKTRISCHEN KONTAKTES**
METHOD FOR PRODUCING AN ELECTRIC CONTACT
PROCÉDÉ POUR CRÉER UN CONTACT ÉLECTRIQUE

(30) Priorität: 06.08.2018 DE 102018119032
(43) Veröffentlichungstag der Anmeldung: 16.06.2021
(73) Patentinhaber: Lang, Lisa, 1050 Bruxelles (BE)
(72) Erfinder: Lang, Lisa, 1050 Bruxelles (BE)
(74) Vertreter: Gramm, Lins & Partner Patent- und Rechtsanwälte PartGmbB
(86) Internationale Anmeldenummer: PCT/EP2019/071145
(87) Internationale Veröffentlichungsnummer: WO 2020/030655

(56) Entgegenhaltungen:
- DE-A1-102016 224 568
- US-A1- 2004 244 193
- US-A1- 2008 066 306
- US-A1- 2010 101 858
- US-A1- 2012 030 935

## Beschreibung

Die Erfindung betrifft ein Verfahren zum Herstellen eines elektrischen Kontaktes zwischen mehreren ersten Fasern und mehreren zweiten Fasern.

Heute werden eine Vielzahl unterschiedlicher Kleidungsstücke entworfen und hergestellt, in die elektrische Verbraucher, also Geräte, die elektrischen Strom benötigen, integriert sind. Dies kann beispielsweise aus ästhetischen und modischen Gründen geschehen und beispielsweise Leuchtelemente, beispielsweise LED's betreffen. Diese werden an oder in den Kleidungsstücken angeordnet und mit einer Stromversorgung versehen. Insbesondere Leuchtelemente, aber auch andere elektrische Verbraucher können auch für Einsatzkräfte verwendet werden, um beispielsweise Feuerwehrleute oder Polizisten leicht erkennbar und sichtbar zu machen. Auch Lautsprecher oder Mikrofone können in Kleidungsstücke sinnvoll integriert werden, um beispielsweise Funkverbindungen zwischen sich im Einsatz befindenden Einsatzkräften und der Zentrale oder einer Leitstelle aufzubauen und aufrechtzuerhalten, ohne dass die betreffende Einsatzkraft ein Funkgerät per Hand bedienen muss. Elektrische Verbraucher können selbstverständlich auf Positionssensoren oder GPS-Sensoren sein, die aus empfangenen GPS-Signalen ihre Position ermitteln und beispielsweise an eine Leitstelle weitergeben können. Insbesondere bei großen und unübersichtlichen Einsätzen kann auf diese Weise leicht der Überblick über die Positionen der einzelnen Einsatzkräfte erhalten werden.

Bekannt ist die Verwendung von elektrisch betriebenen Heizelementen in Kleidungsstücken, beispielsweise Jacken, um ausreichende Wärme für den Träger zu gewährleisten. Dies ist beispielsweise bei Jägern von Vorteil, die sich über lange Zeit in ggf. kalter Umgebung ruhig verhalten müssen.

Soll ein Kleidungsstück mit elektrischen Verbrauchern und einer Stromversorgung versehen werden, wird heute herkömmlicherweise das Kleidungsstück hergestellt und anschließend die benötigte Verkabelung aufgebracht. Eine entsprechende Ausgestaltung ist beispielsweise aus der EP 2 133 809 B1 bekannt. Sie beschreibt ein Bekleidungsstück mit mindestens zwei Kleidungsstücken, beispielsweise einer Jacke mit einer Kapuze, wobei die elektrische Verbindung zwischen den beiden Kleidungsstücken beispielsweise über Druckknöpfe erreicht wird.

Die US 2012/030935 A1) beschreibt die Verbindung von elektrisch leitenden Fasern in Textilien. Die Fasern sind von einer Isolierung umgeben, die zum Verbinden aufgeschmolzen wird. Beim späteren Erhärten entsteht die gewünschte Verbindung. Ein ähnliches Verfahren ist aus der US 2004/244193 A1 bekannt.

Aus der US 2010/101858 A1, die den Oberbegriff des Anspruchs 1 offenbart, ist ein Verfahren bekannt, bei dem eine Vielzahl von elektrisch leitfähigen Fasern in einem Textil mit einem einzigen elektrisch leitenden Element verbunden werden, um die Fasern an eine Stromversorgung anzuschließen.

Die US 2008/066306 A1 befasst sich mit einer Art Textilniet, der durch zu verbindende Element hindurchgestochen und dann durch ein geeignetes Werkzeug umgeformt wird.

Die nachträgliche Ausrüstung von Kleidungsstücken mit elektrischer Verkabelung und elektrischen Verbrauchern sowie einer Stromversorgung ist aufwendig, unhandlich und daher kostenintensiv. Der Erfindung liegt daher die Aufgabe zugrunde, ein Verfahren zu verbessern, dass diese Nachteile vermieden oder zumindest vermindert werden.

Die Erfindung löst die gestellte Aufgabe durch ein Verfahren gemäß Anspruch 1.

Durch das erfindungsgemäße Verfahren ist es folglich möglich, einen elektrischen Kontakt zwischen einer ersten Faser und einer zweiten Faser herzustellen, die beispielsweise Fäden in einem Textil sein können. Die erste Faser und die zweite Faser sind vorteilhafterweise elektrisch leitfähig ausgebildet. Dies kann beispielsweise erreicht werden, in dem die Fasern als dünne metallische Drähte oder mit einem elektrisch leitfähigen Material, beispielsweise Ruß oder Metall beschichtete Textile oder Kohlenstofffasern sind. Eine Faser im Sinne der vorliegenden Anmeldung kann jedoch auch auf ein Textil oder ein sonstiges Trägermaterial aufgedruckt sein. Die Faser ist dann aus einem elastischen, zumindest aber flexiblem Material auf das Trägermaterial aufgebracht, beispielsweise aufgedruckt oder aufgespritzt. Das Material ist beispielsweise ein elektrisch leitfähiges Polymer, das beispielsweise mit elektrisch leitfähigen Partikeln vermischt ist. Diese sind beispielsweise Metallpartikel, Kohlenstoffpartikel wie Kohlenstoffnanoröhren oder Rußpartikel. Alternativ oder zusätzlich dazu könenn die Fasern auch in Form von zweidimensionalen Elementen, beispielsweise Membranen ausgebildet sein, auf die elektrische Leiterbahnen aufgebracht, beispielsweise aufgedruckt, oder in sie eingebracht sind. Diese zweidimensionalen Elemente sind bevorzugt zwischen zwei Textillagen angeordnet und haben vorzugsweise zumindest deren Elastizität und/oder Flexibilität. Um nun einen elektrischen Kontakt zwischen der ersten Faser, die selbst elektrisch leitfähig ausgebildet ist, und der zweiten Faser, die ebenfalls elektrisch leitfähig ausgebildet ist, herzustellen, werden die beiden Fasern in einer Verbindungsvorrichtung positioniert. Dabei kommen sie in Kontakt mit dem elektrisch leitfähigen Element der Verbindungsvorrichtung, sodass über dieses elektrisch leitfähige Element der elektrische Kontakt zwischen der wenigstens einen ersten Faser und der wenigstens einen zweiten Faser hergestellt wird. In diesem Zustand wird dann die erste Faser und die zweite Faser an der Verbindungsvorrichtung fixiert, sodass der elektrische Kontakt auch dann aufrechterhalten wird, wenn die so verbundenen Fasern mechanischer Belastung, wie sie beispielsweise beim Tragen eines Kleidungsstückes auf die Fasern wirken können, ausgesetzt werden.

Das elektrisch leitfähige Element der Verbindungsvorrichtung weist bevorzugt ein Trägermaterial auf, die als doppelseitiges Klebeband mit integrierten elektrisch leitfähigen Partikeln, vorzugsweise aus Metall, ausgebildet ist. Ein solches Klebeband ist beispielsweise unter der Bezeichnung "Z-Tape" erhältlich. Durch die elektrisch leitfähigen Partikel kann ein elektrischer Strom lediglich in z-Richtung, also von einer Oberseite des Klebebandes zu einer gegenüberliegenden Unterseite des Klebebands oder umgekehrt fließen. Ein Stromfluss parallel zur Oberseite oder zur Unterseite ist ausgeschlossen, da nicht ausreichend Partikel vorhanden sind, um die Perkolationsschwelle zu überschreiten. Diese Art Klebeband hat den Vorteil, dass sie nicht exakt zu der wenigstens einen ersten Faser und/oder der wenigstens einen zweiten Faser ausgerichtet werden muss. Fertigungstoleranzen oder Ungenauigkeiten werden ausgeglichen, da das Klebeband über seine gesamte Oberseite und Unterseite einen elektrischen Kontakt ausschließlich in einer Richtung zwischen diesen beiden Seiten erlaubt.

Vorzugsweise verfügt die Verbindungsvorrichtung auf der der ersten Faser und der zweiten Faser abgewandten Seite über eine elektrisch leitfähige Schicht, beispielsweise ein elektrisch leitfähiges Textil, ein Metallgewebe oder Ähnliches.

Vorzugsweise verfügt die Verbindungsvorrichtung auf der dem Klebeband abgewandten Seite der elektrisch leitfähigen Schicht über eine Ausgleichsschicht, beispielsweise in Form eines viskosen Kunststoffes, Klebstoffes oder anderen Ausgleichsmaterials. Dadurch können auftretende Unebenheiten ausgeglichen werden. Zudem wird eine mechanische Stabilisierung und eine elektrische Isolierung der darunterliegenden elektrischen Kontaktbereiche erreicht.

Eine Abdeckschicht oder Umhüllungslage beispielsweise aus einem thermoplastischen Kunststoff wird verwendet, um die mechanische Stabilität und die elektrische Isolierung zu verstärken. Diese Abdeckschicht oder Umhüllungslage ist unabhängig von dem sonstigen Aufbau der Verbindungsvorrichtung von Vorteil.

Erfindungsgemäß beinhaltet die Abdeckschicht oder die Umhüllungslage eine wasserfeste, insbesondere waschfeste Schicht, durch die die elektrische Verbindung zwischen der ersten Faser und dem elektrisch leitfähigen Element und/oder zwischen der zweiten Faser und dem elektrisch leitfähigen Element wasserfest, insbesondere waschfest eingekapselt wird. Die Abdeckschicht oder Umhüllungslage ist bevorzugt als eine solche wasserfeste, bevorzugt waschfeste, Schicht ausgebildet. Dadurch wird vermieden, dass ein weiterer Arbeitsschritt bei der Herstellung nötig ist. Es ist jedoch auch denkbar, dass eine zusätzliche Schicht aus einem wasserfesten, bevorzugt waschfesten, Material verwendet wird, so dass die Abdeckschicht oder Umhüllungsschicht aus mehreren Schichten besteht. Diese Schichten können aus unterschiedlichen Materialien bestehen. Sie können gleichzeitig oder nacheinander verarbeitet werden.

In einer bevorzugten Ausgestaltung deckt die wasserfeste, insbesondere waschfeste Schicht nicht nur die Verbindung zwischen der ersten Faser und dem leitfähigen Element und der zweiten Faser und dem leitfähigen Element ab. Bevorzugt ist die erste Faser und/oder die zweite Faser elektrisch mit einem elektrischen Verbraucher und/oder einer elektrischen Energiequelle verbunden. Ein solcher Verbraucher ist beispielsweise ein Sensor, eine elektronische Datenverarbeitungseinrichtung, beispielsweise ein Mikrochip, oder eine Lichtquelle, ein Mikrofon oder ein sonstiger elektrischer Verbraucher. Als Energiequelle können Solarzellen, Piezo-Elemente oder Batterien und Akkus verwendet werden. Alle diese Elemente sind mit jeweils einem elektrischen Leiter, bevorzugt der ersten Faser und/oder der zweiten Faser, verbunden. Es hat sich als vorteilhaft herausgestellt, wenn der elektrische Verbraucher und/oder die elektrische Energiequelle von der wasserfesten, insbesondere waschfeste Schicht mit abgedeckt, besonders bevorzugt vollständig umgeben wird. Selbst verständlich ist es auch möglich, einen solchen Verbraucher und/oder eine solche Energiequelle mit mehreren Verbindungen zwischen ersten Fasern und zweiten Fasern in der wasserfesten, insbesondere waschfeste Schicht einzukapseln.

Während eine wasserfeste Schicht die in ihr enthaltenen Bauteile und Elemente vor Wasser schützt, beispielsweise Regen oder Spritzwasser, bietet eine waschfeste Schicht auch Schutz vor höheren Temperaturen, wie sie beispielsweise beim Waschen von Kleidungsstücken auftreten sowie den Substanzen, die in Waschmitteln und Seife enthalten sind.

In einer bevorzugten Ausgestaltung ist die wasserfeste, bevorzugt waschfeste Schicht transparent ausgebildet. Dies ist insbesondere dann von Vorteil, wenn ein elektrischer Verbraucher mit geschützt wird, der eine Lichtquelle, beispielsweise eine LED, beinhaltet.

Bevorzugt ist die wasserfeste, bevorzugt waschfeste Schicht aus einem elastischen, mindestens jedoch flexible Material hergestellt. Auf diese Weise wird verhindert, dass die flexiblen und gegebenenfalls elastischen Eigenschaften von Textilien, in denen die erste Faser und/oder die zweite Faser enthalten ist, durch die wasserfeste, bevorzugt waschfeste Schicht verändert werden.

In einer bevorzugten Ausgestaltung erfolgt das Fixieren der wenigstens einen ersten Faser und der wenigstens einen zweiten Faser an der Verbindungsvorrichtung durch Nähen, Kleben oder Schweißen.

Werden die erste Faser und/oder die zweite Faser an der Verbindungsvorrichtung angenäht, also durch Nähen an ihr fixiert, geschieht dies vorzugsweise durch ein elektrisch leitfähiges Garn. In einer ersten Ausgestaltung dieser Ausführungsform hat die Verbindungsvorrichtung eine Trägerlage, auf der das elektrisch leitfähige Element angeordnet ist. Dieses wenigstens eine elektrisch leitfähige Element dient als Brücke zwischen der ersten Faser und der zweiten Faser. In einer anderen Ausgestaltung der Ausführungsform, bei der die erste Faser und die zweite Faser an der Verbindungsvorrichtung durch Nähen fixiert werden, besteht die Verbindungseinrichtung vollständig oder zumindest im Wesentlichen aus dem elektrisch leitfähigen Garn. Das elektrisch leitfähige Garn bildet dann selbstverständlich auch das elektrisch leitfähige Element der Verbindungsvorrichtung. Die erste Faser und die zweite Faserwerden dabei so aneinander angeordnet, dass beim Nähen mit dem elektrisch leitfähigen Gern ein elektrischer Kontakt zwischen dem elektrisch leitfähigen garn und der wenigstens einen ersten Faser und ein elektrischer Kontakt zwischen dem elektrisch leitfähigen garn und der wenigstens einen zweiten Faser hergestellt wird. Besonders bevorzugt kommt es zudem zu einem direkten elektrischen Kontakt zwischen der wenigstens einen ersten Faser und der wenigstens einen zweiten Faser.

Selbstverständlich kann auch ein elektrisch nicht leitfähiges Garn zum Nähen verwendet werden, wenn schergestellt ist, dass dadurch ein elektrischer Kontakt zwischen dem elektrisch leitfähigen Element der Verbindungsvorrichtung und der wenigstens einen ersten Faser und zwischen dem elektrisch leitfähigen Element der Verbindungsvorrichtung und der wenigstens einen zweiten Faser hergestellt wird.

In einer besonders bevorzugten Ausgestaltung verfügt die Verbindungsvorrichtung dazu über eine Fixierungsschicht aus einem Fixierungsmaterial, das insbesondere als Thermoplast ausgebildet ist. Dieses Material wird zum Fixieren durch Erhitzen, beispielsweise durch Bügeln, aufgeschmolzen oder zumindest soweit aufgeweicht, dass es eine Verbindung mit den Enden der jeweils wenigstens einen ersten Faser und der wenigstens einen zweiten Faser eingeht. Nachdem das Material abkühlt härtet es aus und es kommt zu einer dauerhaften Verbindung und Fixierung der Fasern mit der Fixierungsschicht und der Rest der Verbindungsvorrichtung. Die Fixierungsschicht ist nach dem Abkühlen zwar ausgehärtet, dies bedeutet jedoch nicht, dass sie nicht flexibel oder gar elastisch ausgebildet sein kann. Vielmehr haben flexible und insbesondere elastische Fixierungsmaterialien den Vorteil, den mechanischen Belastungen, die beispielsweise beim Tragen von Kleidung wirken können, besser standhalten zu können. Durch ihre Flexibilität und insbesondere Elastizität wird zudem der Tragekomfort von Kleidungsstücken, die Fasern aufweisen, die durch diese Art von Verbindungsvorrichtungen miteinander verbunden sind erhöht.

Die Verwendung dieser Art von Verschweißungen, bei der ein Fixierungsmaterial aufgeschmolzen oder erweicht wird, ist es zur Verbindung mit den Faserenden kommt, hat den großen Vorteil, dass sie eine saubere, gut handhabbare und dennoch schnelle und damit kostengünstige Art ist, die erste Faser und die zweite Faser an der Bindungsvorrichtung zu fixieren. Die Fixierungsschicht aus Fixierungsmaterial ist im nicht erwärmten Zustand problemlos handhabbar, da sie weder klebt noch schmiert. Die Menge des benötigten Fixierungsmaterials kann sehr leicht dimensioniert werden, indem beispielsweise die Fixierungsschicht als Streifen aus Fixierungsmaterial ausgebildet ist. Dieser Streifen kann an einem anderen Bauteil der Verbindungsvorrichtung befestigt, beispielsweise angenäht sein, sodass er auch nicht verlierbar ist.

Das Erhitzen insbesondere durch ein Bügeleisen benötigt keine lange Zeit und kann daher auch bin industriellem Maßstab eingesetzt werden.

Ist dies trotzdem nicht gewünscht, kann die Fixierung selbstverständlich auch auf andere Weise, insbesondere durch Nähen erfolgen. Die Enden der wenigstens einen ersten Faser und der wenigstens einen zweiten Faser werden in diesem Fall mit der Verbindungsvorrichtung derart vernäht, dass es zu einem dauerhaften Kontakt der jeweiligen Fasern mit dem elektrisch leitfähigen Element der Verbindungsvorrichtung kommt. Dies hat den Vorteil, dass keine separaten Maschinen oder Vorrichtungen benötigt werden, da zum Verbinden verschiedener textiler Elemente ohnehin Nähmaschinen verwendet werden.

Vorzugsweise sind die erste Faser und die zweite Faser textile Fasern oder Fäden, Kohlefasern oder metallische Drähte. Auch andere elektrisch leitfähige Elemente sind möglich.

In einer bevorzugten Ausgestaltung des Verfahrens sind die erste Faser und/oder die zweite Faser jeweils Teil eines Textils, insbesondere eines Vlieses, eines Gestrickes oder eines Gewebes. Darunter fallen beispielsweise auch Gewebeelemente, die aus Kohlefasern bestehen und zur Herstellung von Kohlefaserverbundwerkstoffen verwendet werden. Herkömmlicherweise werden derartige Textilien miteinander verbunden, indem sie miteinander vernäht werden. Lediglich bei der Herstellung von Glasfaser- und Kohlefaserverbundwerkstoffen werden die einzelnen Textilelemente über Kunstharze miteinander verklebt. Ohne die elektrische Verbindung zwischen der wenigstens einen ersten Faser und der wenigstens einen zweiten Faser, die vorteilhafterweise elektrisch leitfähig ausgebildet sind, herzustellen, müssen diese miteinander verbunden werden, indem sie jeweils mit dem elektrisch leitfähigen Element der Verbindungsvorrichtung in Kontakt gebracht und anschließend fixiert werden. Dazu kann die wenigstens eine erste Faser und/oder die wenigstens eine zweite Faser zumindest ein Teilstück aus dem jeweiligen Textil herausgezogen werden, um sie so miteinander verbinden zu können.

Erfindungsgemäß verfügt die Verbindungsvorrichtung über eine Umhüllungslage, beispielsweise aus einem Textil, insbesondere einem Gewebe, die vor dem Fixieren der Fasern derart gefaltet und/oder umgeschlagen wird, dass sie das elektrisch leitfähige Element vollständig umgibt. Dadurch werden die elektrisch leitfähigen Bestandteile und insbesondere die elektrischen Kontakte zwischen den elektrisch leitfähigen Bestandteilen abgedeckt, was einerseits dazu führt, dass auch bei mechanischer Belastung und Beschädigung die elektrischen Kontakte einen gewissen Schutz unterworfen sind und andererseits die elektrischen Kontakte und die elektrisch leitfähigen Elemente gegenüber der Umgebung, insbesondere weiteren Bestandteilen von Kleidung, isoliert sind. Das Material der Umgebungslage ist vorteilhafterweise elektrisch isolierend ausgebildet. Vorteilhafterweise werden mehrere, vorzugsweise zwei, drei, vier oder fünf erste Fasern mit mehreren, vorzugsweise zwei, drei, vier oder fünf zweiten Fasern verbunden. Vorzugsweise sind die ersten Fasern und/oder die zweiten Fasern durch Abstandshalter miteinander verbunden.

Dies ist insbesondere dann von Vorteil, wenn die verschiedenen Fasern, die elektrisch leitfähig ausgebildet sind, nicht nur zur Übertragung von elektrischen Strom verwendet werden, sondern beispielsweise auch als Datenleitung, beispielsweise als Bus-Leitung verwendet werden. Die Verwendung von Abstandshaltern oder sonstigen Verbindungsvorrichtungen, die die jeweiligen ersten Fasern oder die jeweiligen zweiten Fasern miteinander verbinden, macht die Handhabbarkeit des Verfahrens deutlich einfacher. Selbstverständlich verfügt in diesem Fall die Verbindungsvorrichtung vorteilhafterweise über mehrere elektrisch leitfähige Elemente, wobei die Anzahl der elektrisch leitfähigen Elemente der Anzahl der Verbindungen zwischen den jeweiligen Fasern entspricht, die hergestellt werden sollen. Sollen also fünf erste Fasern mit fünf zweiten Fasern verbunden werden, verfügt die Verbindungsvorrichtung vorteilhafterweise auch über wenigstens fünf elektrisch leitfähige Elemente. Durch die Abstandhalter wird nicht nur die jeweiligen ersten Fasern oder die jeweiligen zweiten Fasern in einem für die Anordnung in der Verbindungsvorrichtung optimalen Abstand zueinander gehalten, auch die Reihenfolge oder Sortierung der einzelnen Fasern, die als Strom- oder Datenkabel verwendet werden sollen, ist vordefiniert und kann nicht versehentlich vertauscht werden, was zu einer fehlerhaften Verdrahtung oder Verbindung der einzelnen Fasern untereinander und damit zu Fehlfunktionen bei den elektrischen Verbrauchern führen kann.

Die Erfindung löst die gestellte Aufgabe zudem durch ein Verfahren zum Verbinden eines ersten Textilelementes, das wenigstens eine erste Faser aufweist, mit einem zweiten Textilelement, das wenigstens eine zweite Faser aufweist mittels einer Verbindungsvorrichtung, die wenigstens ein elektrisch leitfähiges Element aufweist, wobei das Verfahren die folgenden Schritte aufweist: A) Verbinden der wenigstens einen ersten Faser mit der wenigstens einen zweiten Faser nach einem hier beschriebenen Verfahren und B) Verbinden des ersten Textilelementes mit dem zweiten Textilelement, insbesondere durch Vernähen.

Diese Verfahren können bei der Herstellung von Kleidungsstücken verwendet werden, die aus mehreren Textilelementen, die separat zugeschnitten werden, hergestellt werden. Herkömmlicherweise werden diese Textilelemente miteinander vernäht, wobei auf eine Verbindung einzelner Fasern zueinander kein Wert gelegt wird. Da bei Kleidungsstücken, die eine Verdrahtung oder Verkabelung beinhalten sollen, derartige Verbindungen zwischen einzelnen Fasern, nämlich zwischen ersten Fasern und zweiten Fasern, nötig, sinnvoll und wichtig sind, werden diese separat nach dem hier beschriebenen Verfahren miteinander verbunden.

Vorteilhafterweise werden dabei zunächst die Textilelemente miteinander verbunden, bevor die Fasern miteinander verbunden werden. Auf diese Weise wird zunächst eine ausreichende Stabilität der Verbindung zwischen den Textilelementen bereitgestellt, bevor die einzelnen Fasern miteinander verbunden werden. Selbstverständlich ist es auch möglich, zunächst die wenigstens eine erste Faser mit der wenigstens einen zweiten Faser zu verbinden und erst danach die Textilelemente miteinander zu verbinden.

Vorzugsweise ist die Verbindungsvorrichtung an dem ersten Textilelement befestigt und die wenigstens eine erste Faser mit dem elektrisch leitfähigen Element verbunden. Auf diese Weise muss die Verbindungsvorrichtung nicht als separates Element zugeführt werden, was eine erhöhte Verlierbarkeit zur Folge hat. Ist die Verbindungsvorrichtung bereits an einem Textilelement befestigt, kann es nicht nur nicht verloren werden, auch die Positionierung der wenigstens einen ersten Faser kann bereits stattgefunden haben. Dazu ist es von Vorteil, wenn die wenigstens eine Faser zumindest provisorisch eine Verbindungsvorrichtung angeordnet ist, sodass die Faser mit dem elektrisch leitfähigen Element der Verbindungsvorrichtung Kontakt hat. Die eigentliche Fixierung erfolgt dann zu einem späteren Zeitpunkt, wenn auch die wenigstens eine zweite Faser Kontakt mit dem elektrisch leitfähigen Element hat.

Der elektrische Kontakt zwischen der ersten Faser und dem elektrisch leitfähigen Element der Verbindungsvorrichtung und/oder der elektrische Kontakt zwischen der zweiten Faser und dem elektrisch leitfähigen Element der Verbindungsvorrichtung kann beispielsweise auch hergestellt werden, in dem die Verbindungsvorrichtung auf die bereits verbundenen Textilelemente, die vorteilhafterweise vernäht sind, aufgelegt wird. Dies geschieht vorteilhafterweise so, dass das elektrisch leitfähige Element in Kontakt mit dem jeweils gewünschten Fasern kommt, sodass die elektrische Verbindung hergestellt wird. Die Verbindungsvorrichtung verfügt dann vorteilhafterweise über eine Fixierungsschicht aus einem Fixierungsmaterial, das vorteilhafterweise durch Aufbügeln mit dem verbundenen Textilelement verbunden wird.

Die Verbindungsvorrichtung mit ihrem elektrisch leitfähigen Element dient vorzugsweise als Brücke, um die Naht, mit der die beiden Textilelemente verbunden werden zu überbrücken. In diesem Fall ist es von Vorteil, wenn zunächst die Textilelemente verbunden werden. Durch eine solche Überbrückung können Ungenauigkeiten in der Positionierung der Textilelemente zueinander, die eine ebenso ungenaue Positionierung der wenigstens einen ersten Faser und der wenigstens einen zweiten Faser zueinander zur Folge haben, ausgeglichen werden. Zudem können Fehler oder Beschädigungen der zu verbindenden Fasern, beispielsweise durch Korrosion der Enden der Fasern, überbrück werden.

Diese Beschreibung präsentiert ebenfalls eine Verbindungsvorrichtung für ein hier beschriebenes Verfahren, das wenigstens ein elektrisch leitfähiges Element aufweist. Dieses ist vorteilhafterweise als Metallstreifen oder elektrisch leitfähiges Textil, beispielsweise beschichtetes Gewebe oder Vlies ausgebildet. Vorzugsweise verfügt die Verbindungsvorrichtung über eine Umhüllungslage, beispielsweise in Form einer Textillage, die vorzugsweise größere Abmessungen als das elektrisch leitfähige Element aufweist. Nachdem die erste Faser und die zweite Faser an dem elektrisch leitfähigen Element positioniert wurden, kann diese Umhüllungslage umgeschlagen, gefaltet oder aufgerollt werden, um die elektrisch leitfähigen Elemente und insbesondere den elektrischen Kontakt zwischen diesen Elementen zu umhüllen. Auf diese Weise wird die elektrische Kontaktierung vor Beschädigungen und Verschmutzungen geschützt und zudem eine elektrische Isolierung gegenüber der Umgebung erreicht.

Mit Hilfe der beiliegenden Figuren wird nachfolgend ein Ausführungsbeispiel der vorliegenden Erfindung näher erläutert. Es zeigt
- Figur 1 -: eine teilweise Explosionszeichnung von nach einem Verfahren gemäß einem Ausführungsbeispiel der vorliegenden Erfindung miteinander verbundenen Fasern sowie eine Schnittdarstellung durch eine derartige Verbindung,
- Figuren 2 und 3 -: schematische Darstellungen weiterer Ausführungsbeispiele der vorliegenden Erfindung,
- Figuren 4 und 5 -: zwei Schnittdarstellungen durch Verbindungen gemäß weiterer Ausführungsbeispiele der vorliegenden Erfindung,
- Figur 6.1 bis 6.3 -: verschiedene Verfahrensschritte zum Herstellen einer solchen Verbindung,
- Figur 7 -: die schematische Darstellung einer Verbindung gemäß einem weiteren Ausführungsbeispiel der vorliegenden Erfindung,
- Figur 8 -: eine schematische Explosionszeichnung einer Verbindungsvorrichtung und
- Figuren 9 & 10 -: schematische Darstellungen weiterer Ausführungsbeispiele.

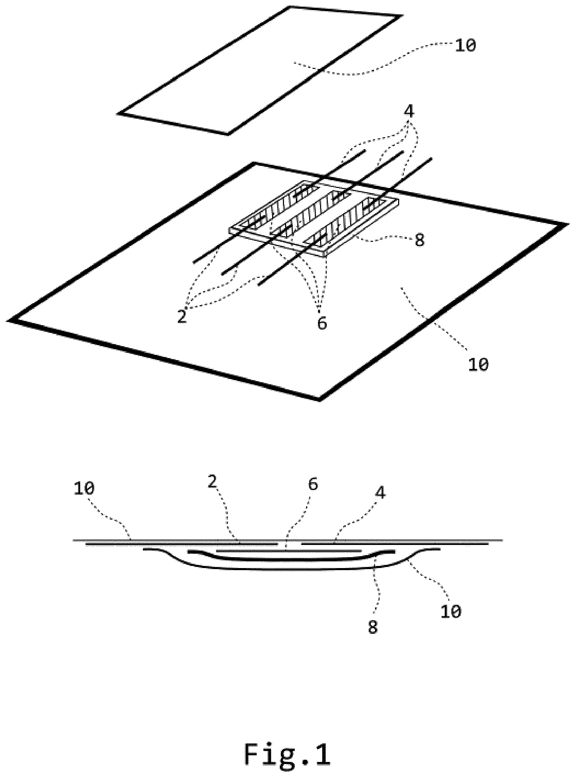

Figur 1 zeigt schematisch drei erste Fasern 2 sowie drei zweite Fasern 4. Diese werden durch eine in Teilexplosion dargestellte Verbindungsvorrichtung miteinander verbunden. Diese verfügt über drei elektrisch leitfähige Elemente 6 die im gezeigten Ausführungsbeispiel auf einer Trägerlage 8 angeordnet sind. Die Trägerlage 8 kann beispielsweise mit einem Klebstoff beschichtet sein, sodass die elektrisch leitfähigen Elemente 6 auf der Trägerlage 8 haften. Alternativ dazu können sie auch aufgenäht oder auf sonstige Weise befestigt sein. In einer besonders bevorzugten Ausgestaltung handelt es sich bei der Trägerlage 8 bereits um eine Fixierungsschicht aus einem Fixierungsmaterial, das beispielsweise durch Einwirken von Hitze aufgeschmolzen werden kann. Die in Figur 1 gezeigte Verbindungsvorrichtung verfügt über zwei Umhüllungslagen 10, die einerseits als Schicht vor Verschmutzung und Beschädigung dienen und andererseits eine elektrische Isolierung gegenüber der Umgebung hervorrufen.

Nachdem die ersten Fasern 2 und die zweiten Fasern 4 wie in Figur 1 dargestellt angeordnet wurden, wobei eine vorläufige Befestigung beispielsweise über eine einfach Naht, ein Klebstoff oder eine sonstige Positionierungshilfe möglich ist, werden die Umhüllungslagen 10 angeordnet und der gesamte Schichtaufbau erwärmt. Dies kann beispielsweise über ein Bügeleisen oder eine Bügelvorrichtung geschehen. Handelt es sich bei der Trägerlage 8 um eine Fixierungsschicht schmilzt das Fixierungsmaterial auf und sorgt für eine dauerhafte Verbindung zwischen den ersten Fasern 2 und den zweiten Fasern 4 sowie der elektrisch leitfähigen Elemente 6 in der rechten unteren Ecke der Figur 1 ist der Schichtaufbau in einer Schnittdarstellung dargestellt. Man erkennt die Umhüllungslagen 10, die auf beiden Seiten den gesamten Schichtaufbau abdecken. Das Material der Trägerlage 8 hat sich um die elektrisch leitfähigen Elemente 6 sowie ersten Fasern 2 und die zweiten Fasern 4 herumgelegt und sorgt für eine dauerhafte Fixierung der einzelnen Komponenten zueinander.

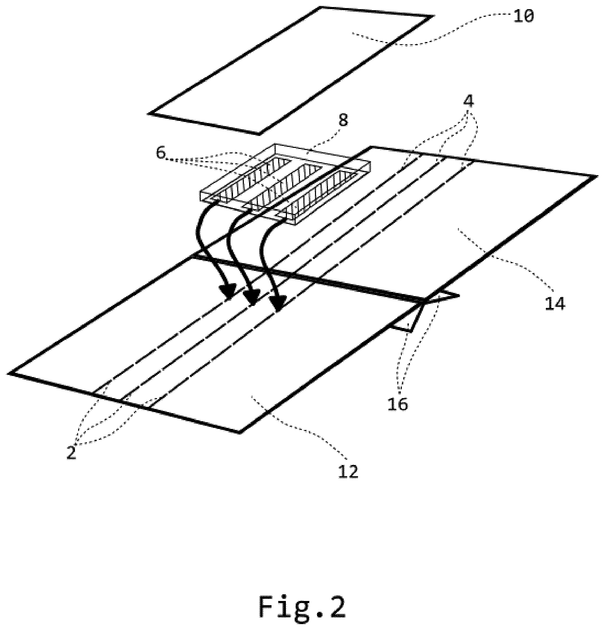

Figur 2 zeigt eine Ausgestaltung, bei der bereits ein erstes Textilelement 12 mit einem zweiten Textilelement 14 verbunden ist. Im gezeigten Ausführungsbeispiel sind die Ränder 16 der beiden Textilelemente 12, 14, an denen die beiden Textilelemente 12, 14 miteinander verbunden sind, nach unten umgeschlagen. Das erste Textilelement 12 verfügt über drei ersten Fasern 2 und das zweite Textilelement 14 verfügt über drei zweite Fasern 4. Diese sind so angeordnet, dass sie im gezeigten vernähten Zustand aufeinander zulaufen. Ein elektrischer Kontakt zwischen den ersten Fasern 2 und den zweiten Fasern 4 kann jedoch nicht gewährleistet werden, sodass eine Verbindungsvorrichtung nötig wird, die darüber dargestellt ist. Auch sie verfügt über die bereits bekannte Trägerlage 8 vorteilhafterweise aus einem Fixierungsmaterial, an deren Unterseite sich die drei elektrisch leitfähigen Elemente 6 befinden. Die Trägerlage 8 mit den elektrisch leitfähigen Elementen 6 wird entsprechend der Pfeile 18 auf die miteinander vernähten Textilelemente 12, 14 aufgesetzt, wobei die Trägerlage 8 und die elektrisch leitfähigen Elemente 6 so positioniert werden, dass die elektrisch leitfähigen Elemente 6 sowohl mit den ersten Fasern 2 als auch mit den zweiten Fasern 4 in Kontakt kommen. Überdeckt wird das Ganze durch eine Umhüllungslage 10. Auch hier wird nach dem Auflegen und der Positionierung der Fasern 2, 4 zu den elektrisch leitfähigen Elementen 6 Wärme appliziert, wodurch das Material der Trägerlage 8 schmilzt und für eine dauerhafte Verbindung sorgt.

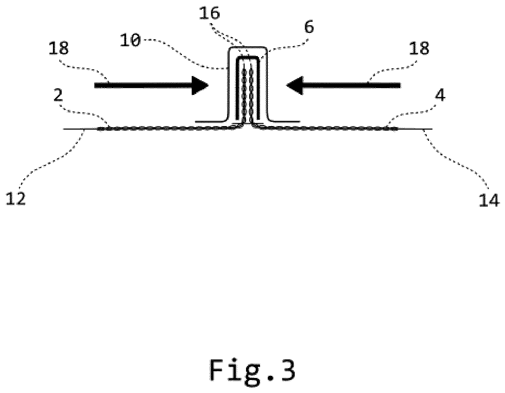

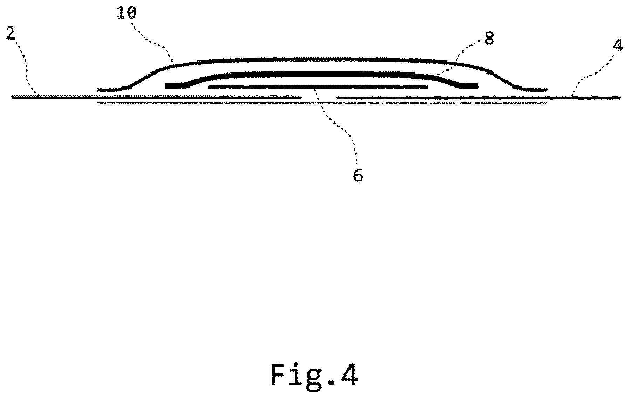

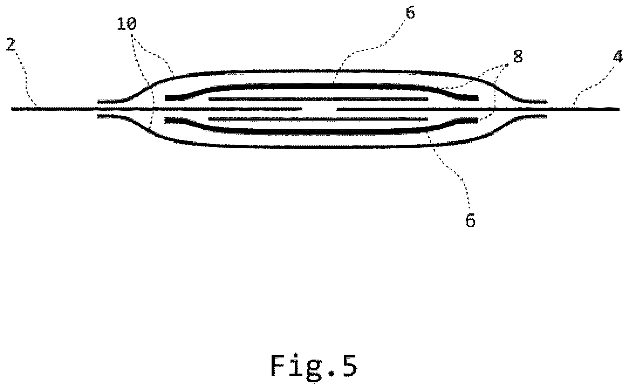

Figur 3 zeigt eine ähnliche Ausgestaltung, bei der wieder ein erstes Textilelement 12 mit einem zweiten Textilelement 14 vernäht ist. Auch hier verfügt das erste Textilelement 12 über eine erste Faser 2 und das zweite Textilelement 14 über eine zweite Faser 4. Anders als im in Figur 2 gezeigten Ausführungsbeispiel sind die Ränder 16 nun jedoch nach oben umgebogen. Auch hier kann ein elektrischer Kontakt zwischen der ersten Faser 2 und der zweiten Faser 4 allein durch das Vernähen nicht gewährleistet werden. Daher wird auch hier ein elektrisch leitfähiges Element 6 so angeordnet, dass es auf der einen Seite der umgeschlagenen Ränder 16 mit der ersten Faser 2 des ersten Textilelementes 12 und auf der zweiten Seite der umgeschlagenen Ränder 16 mit der zweiten Faser 4 des zweiten Textilelementes 14 in Kontakt kommt. Dabei wird das elektrisch leitfähige Element 6 von einem Fixierungsmaterial umgeben, das bei der Applikation von Wärme aufschmilzt. Der Schichtaufbau wird auch hier durch die Umhüllungslage 10 aus elektrisch isolierendem Material abgedeckt. Entsprechend der Pfeile 18 wird nun Wärme appliziert, was die Materialien der Trägerlage 8 bzw. der Fixierungsschicht aufschmelzen lässt und so für eine Verbindung sorgt. Die Figuren 4 und 5 zeigen Schnittdarstellungen durch weitere Verbindungen zwischen den einzelnen Fasern. Man erkennt jeweils eine erste Faser 2, eine zweite Faser 4 sowie dazwischen angeordnete elektrisch leitfähige Elemente 6. Während in Figur 4 nur ein elektrisch leitfähiges Element 6 zum Verbinden der ersten Faser 2 mit der zweiten Faser 4 vorgesehen ist, ist in Figur 5 sowohl oberhalb als auch unterhalb der dargestellten Fasern jeweils ein elektrisch leitfähiges Element 6 dargestellt, sodass hier zwei elektrisch leitfähige Elemente 6 für die Verbindung einer ersten Faser 2 mit einer zweiten Faser 4 vorhanden sind. Abgedeckt werden die Kontakte sowie die elektrisch leitfähigen Elemente 6 wieder durch ein Material der Trägerlage 8, das unter Wärmeeinwirkung aufschmilzt und nach dem Abkühlen und Aushärten für die dauerhafte Verbindung sorgt. Die Besonderheit bei den in Figuren 4 und 5 dargestellten Ausführungsbeispielen besteht in der Umhüllungslage 10, die als Schrumpfschlauch ausgebildet ist und unter der Applikation der Wärme, die auch für das Aufschmelzen der Trägerlage 8 nötig ist, zu einem Schrumpfen führen, sodass eine dauerhafte und sichere Verbindung zwischen den Fasern 2, 4 und der elektrisch leitfähigen Elemente 6 gewährleistet ist.

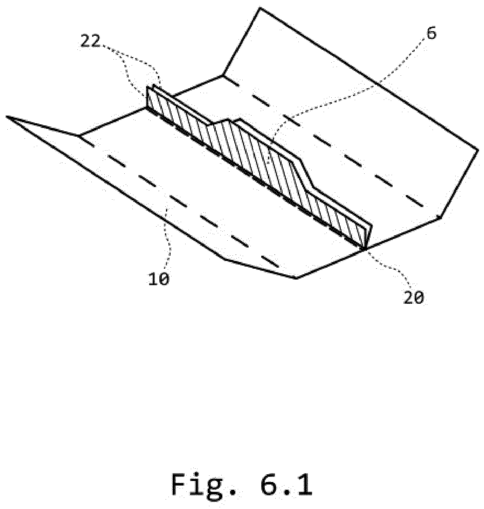

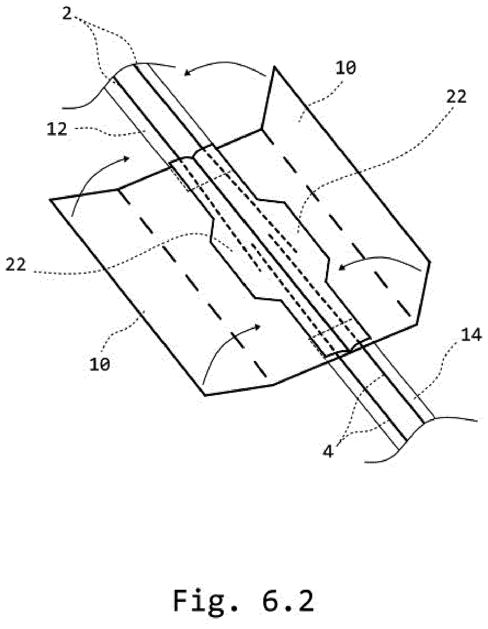

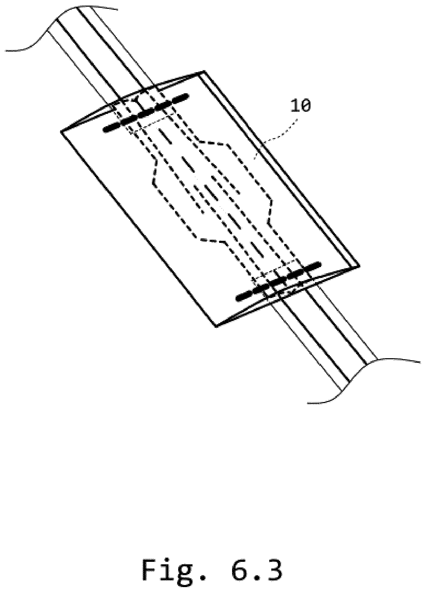

Figur 6 zeigt Verfahrensschritte bei der Herstellung einer derartigen Verbindung. In der linken Darstellung der Figur 6 ist zunächst die Umhüllungslage 10 dargestellt, auf der das elektrisch leitfähige Element 6 in Form eines elektrisch leitfähigen Vlieses durch eine Naht 20 aufgebracht wird. Das elektrisch leitfähige Element 6 verfügt über zwei Flügel 22, die aus der in der linken Darstellung von Figur 6 gezeigten Position nach unten aufgeklappt werden, und so für einen Kontakt zwischen den jeweiligen Fasern, die in dieser Darstellung noch nicht dargestellt sind und dem elektrisch leitfähigen Element 6 sorgen. Dies ist in der mittleren Darstellung der Figur 6 gezeigt. Die beiden Flügel 22 des elektrisch leitfähigen Elementes 6 sind nach unten umgeklappt. Die ersten Fasern 2 und die zweiten Fasern 4 sind bereits auf den Flügeln 22 positioniert. Die beiden Flügel 22 bilden separate elektrisch leitfähige Elemente 6, die gegeneinander isoliert sind. Andernfalls würde es bei der gezeigten Ausführungsform zu einem Kurzschluss zwischen den verschiedenen Leitungen kommen. Die ersten Fasern 2 und die zweiten Fasern 4 sind jeweils Teil eines ersten Textilelementes 12 bzw. eines zweiten Textilelementes 14. Sie stehen über den Rand dieser Textilelemente hinaus, sodass auf besonders einfache Weise der elektrische Kontakt mit den Flügel 22 der elektrisch leitfähigen Elemente 6 hergestellt werden kann. Die einzelnen Seitenflächen der Umhüllungslage 10 können nun umgeschlagen und umgeklappt werden, sodass die elektrischen Elemente und der elektrische Kontakt zwischen diesen abgedeckt werden. Dies ist in der rechten Darstellung von Figur 6 gezeigt, die vollständige Umhüllung der elektrisch leitfähigen Elemente 6 sowie der Enden der Fasern 2, 4 zeigt.

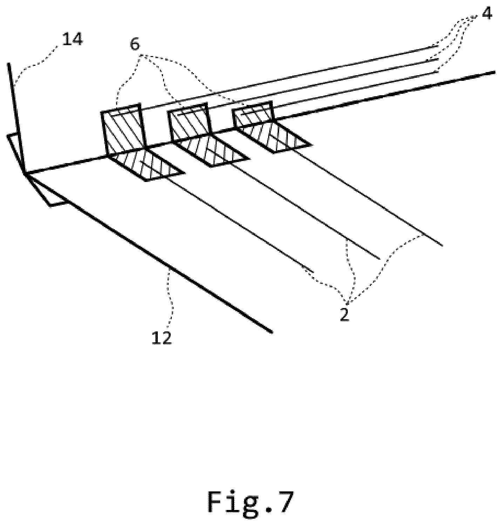

Figur 7 zeigt die Verbindung zweier Textilelemente 12,14 mit einem eingeschlossenen Winkel. Es entsteht eine Ecke, über die die ersten Fasern 2 mit den zweiten Fasern 4 zu verbinden sind. Die Fasern 2, 4 sind mit den elektrisch leitfähigen Elementen 6 in elektrischem Kontakt gebracht und können von einer in Figur 7 nicht gezeigten Umhüllungslage abgedeckt werden.

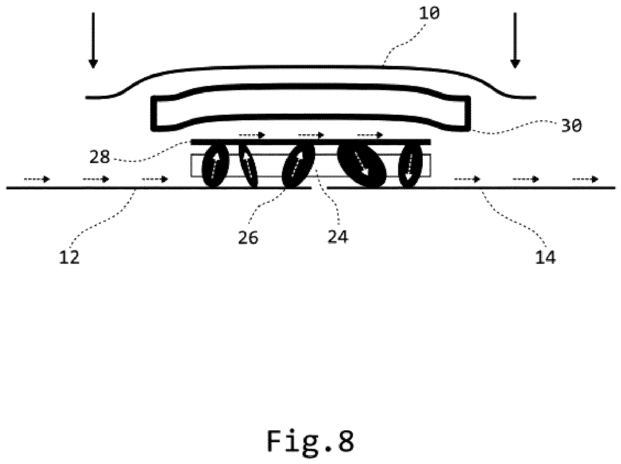

Figur 8 zeigt die schematische Explosionsdarstellung eines Schnittes durch verbundene Textilelemente. Das erste Textilelement 12 sowie das zweite Textilelement 14 verfügen jeweils über nicht dargestellte elektrisch leitfähige Fasern. Die Textilelemente 12, 14 werden durch ein doppelseitiges Klebeband 24 verbunden, in dem sich elektrisch leitfähige Partikel 26 befinden, die mit den ersten und zweiten Fasern in Kontakt kommen und einen Stromfluss in Figur 8 von oben nach unten und umgekehrt erlauben. Darüber ist ein leitfähiges Gewebe 28 angeordnet, das einen Stromfluss in Figur 8 von links nach rechts und umgekehrt erlaubt.

Das leitfähige Gewebe 28 wird abgedeckt durch eine Ausgleichsschicht 30, die als viskoser Kunststoff ausgebildet ist und es neben einer mechanischen Stabilisierung in einer elektrischen Isolierung erlaubt, Unebenheiten, die durch die darunter liegenden Schichten und beispielsweise eine Naht zwischen den beiden Textilelementen 12, 14 hervorgerufen werden, auszugleichen. Dies wird abgedeckt durch die Umhüllungslage 10.

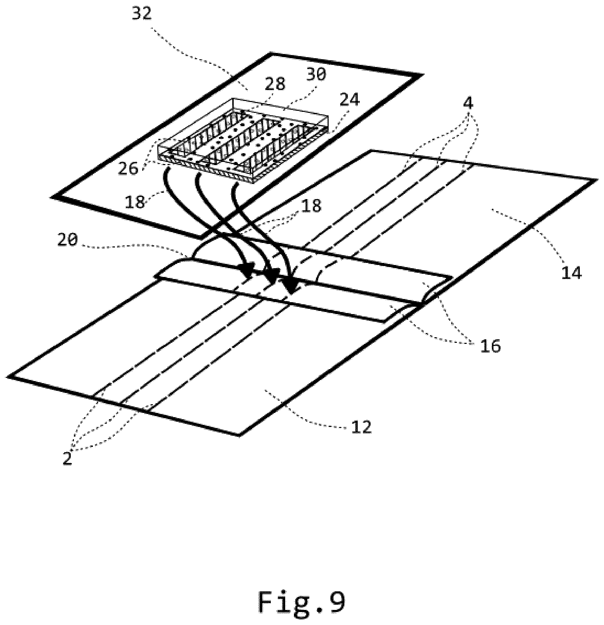

Figur 9 zeigt schematisch den in Figur 8 gezeigten Aufbau in einer schematischen 3D-Ansicht. Das erste Textilelement 12 und das zweite Textilelement 14 sind über eine Naht 20 miteinander verbunden. Im gezeigten Ausführungsbeispiel sind die beiden Ränder 16 der jeweiligen Textilelemente 12, 14 nach oben umgeschlagen. Im ersten Textilelement 12 verlaufen zwei erste Fasern 2, während im zweiten Textilelement 14 zwei zweite Fasern 4 verlaufen. Diese sind durch die Verbindungsvorrichtung 32 elektrisch miteinander zu kontaktieren.

Das doppelseitige Klebeband 24 wird auf die Naht 20, die Ränder 16 und den umgebenen Bereich des ersten Textilelementes 12 und des zweiten Textilelementes 14 aufgeklebt. Die elektrisch leitfähigen Partikel 26 erlauben eine Stromabnahme und eine elektrische Kontaktierung der ersten Fasern 2 und der zweiten Fasern 4. Das elektrisch leitfähige Gewebe 28 ist im gezeigten Ausführungsbeispiel in Form von zwei Streifen ausgebildet, die als Überbrückung der Naht 20 dienen. Sie werden den Pfeilen 18 entsprechend aufgebracht, so dass eine elektrische Kontaktierung der ersten Fasern 2 und der zweiten Fasern 4 ermöglicht wird. Dieser Schichtaufbau wird durch die Ausgleichsschicht 30 und eine darüber liegende nicht gezeigte Umhüllungslage 10 abgedeckt.

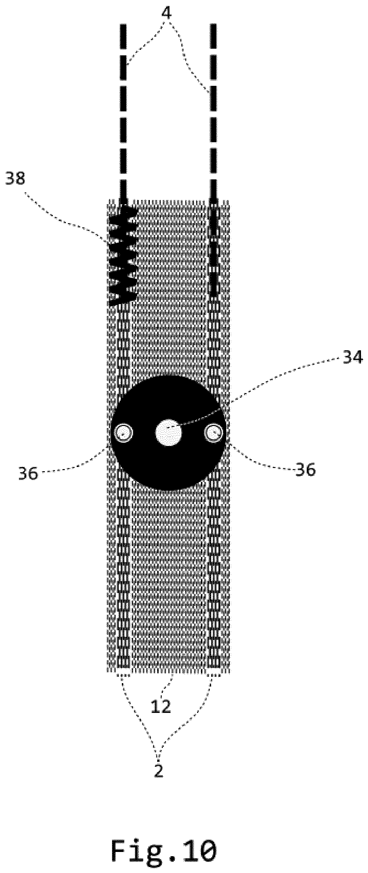

Figur 10 zeigt eine Ausgestaltung, die separat oder als Teil einer anderen Ausgestaltung, beispielswiese der in Figur 9 gezeigten Ausgestaltung, verwendet werden kann.. Dargestellt ist ein erstes Textilelement 12, in dem sich zwei erste Fasern 2 befinden. Diese sollen mit nur schematisch angedeuteten zweiten Fasern 4 eines nicht dargestellten zweiten Textilelementes 14 verbunden werden. Zwischen den ersten Fasern 2 ist eine LED 34 angeordnet, die über zwei Kontaktstellen 36 mit den zwei ersten Fasern 2 in Verbindung steht. Die Verbindung zwischen den ersten Fasern 2 und den zweiten Fasern 4 wird über ein elektrisch leitfähiges Garn 38 erzeugt, durch das die beiden Textilelemente 12, 14 miteinander vernäht werden. Weitere Elemente oder Bauteile sind im gezeigten Ausführungsbeispiel nicht notwendig. Das elektrisch leitfähige Garn 38 bildet folglich die Verbindungsvorrichtung und insbesondere deren elektrisch leitfähiges Element 6.

### Bezugszeichenliste

- 2: erste Faser
- 4: zweite Faser
- 6: elektrisch leitfähiges Element
- 8: Trägerlage
- 10: Umhüllungslage
- 12: erstes Textilelement
- 14: zweites Textilelement
- 16: Rand
- 18: Pfeil
- 20: Naht
- 22: Flügel
- 24: doppelseitiges Klebeband
- 26: elektrisch leitfähige Partikel
- 28: leitfähiges Gewebe
- 30: Ausgleichsschicht
- 32: Verbindungsvorrichtung
- 34: LED
- 36: Kontakstelle
- 38: elektrisch leitfähiges Garn

## Patentansprüche

1. Verfahren zum Herstellen eines elektrischen Kontaktes zwischen mehreren ersten Fasern (2) und mehreren zweiten Fasern (4) mittels einer Verbindungsvorrichtung, die mehrere elektrisch leitfähige Elemente (6) aufweist, wobei das Verfahren die folgenden Schritte aufweist:
A. Positionieren einer ersten Faser (2) an einem elektrisch leitfähigen Element (6),
B. Positionieren einer zweiten Faser (4) an dem elektrisch leitfähigen Element (6), sodass ein elektrischer Kontakt zwischen der ersten Faser (2) und der zweiten Faser (4) hergestellt wird, und
C. Fixieren der ersten Faser (2) und der zweiten Faser (4) an der Verbindungsvorrichtung,
**dadurch gekennzeichnet, dass**
die Verbindungsvorrichtung eine Umhüllungslage (10) aufweist, die derart gefaltet und/oder umgeschlagen wird, dass sie das elektrisch leitfähige Element (6) vollständig umgibt, und die aus einem wasserfesten Material hergestellt ist oder eine Schicht aus einem wasserfesten Material aufweist.

2. Verfahren nach Anspruch 1, **dadurch gekennzeichnet, dass** das Fixieren durch Nähen, Kleben oder Schweißen geschieht, wobei die Verbindungsvorrichtung vorzugsweise eine Fixierungsschicht aus einem Fixierungsmaterial, insbesondere einem Thermoplast, aufweist, die durch Erhitzen, insbesondere Bügeln, geschmolzen oder zumindest aufgeweicht wird und nach dem Abkühlen aushärtet.

3. Verfahren nach Anspruch 1 oder 2, **dadurch gekennzeichnet, dass** die ersten Fasern (2) und die zweiten Fasern (4) textile Fasern oder Fäden, Kohlefasern oder metallische Drähte sind.

4. Verfahren nach einem der vorstehenden Ansprüche, **dadurch gekennzeichnet, dass** die ersten Fasern (2) und/oder die zweiten Fasern (4) jeweils Teil eines Textils, insbesondere eines Vlieses, eines Gestrickes oder eines Gewebes sind.

5. Verfahren nach einem der vorstehenden Ansprüche, **dadurch gekennzeichnet, dass** die Umhüllungslage (10) vor dem Fixieren derart gefaltet und/oder umgeschlagen wird, dass sie das elektrisch leitfähige Element (6) vollständig umgibt.

6. Verfahren nach einem der vorstehenden Ansprüche, **dadurch gekennzeichnet, dass** zwei, drei, vier oder fünf erste Fasern (2) mit zwei, drei, vier oder fünf zweiten Fasern (4) verbunden werden, wobei vorzugsweise die ersten Fasern (2) und/oder die zweiten Fasern (4) durch Abstandshalter miteinander verbunden sind.

7. Verfahren zum Verbinden eines ersten Textilelementes (12), das mehrere erste Fasern (2) aufweist, mit einem zweiten Textilelement (14), das mehrere zweite Fasern (4) aufweist, mittels einer Verbindungsvorrichtung, das wenigstens ein elektrisch leitfähiges Element (6) aufweist, wobei das Verfahren die folgenden Schritte aufweist:
A. Verbinden der ersten Fasern (2) mit den zweiten Fasern (4) nach einem Verfahren gemäß einem der vorstehenden Ansprüche,
B. Verbinden des ersten Textilelementes (12) mit dem zweiten Textilelement (14), insbesondere durch Vernähen.

8. Verfahren nach Anspruch 7, **dadurch gekennzeichnet, dass** zunächst die Textilelemente (12,14) miteinander verbunden werden, bevor die Fasern (2,4) verbunden werden.

9. Verfahren nach Anspruch 7 oder 8, **dadurch gekennzeichnet, dass** die Verbindungsvorrichtung an dem ersten Textilelement (12) befestigt ist und die ersten Fasern (2) mit dem elektrisch leitfähigen Element (6) verbunden sind.

10. Verfahren nach einem der Ansprüche 7 bis 9, **dadurch gekennzeichnet, dass** an dem ersten Textilelement (12) und/oder dem zweiten Textilelement (14) ein elektrischer Verbraucher und/oder eine elektrische Energiequelle angeordnet ist, die von der Umhüllungslage (10) vollständig umgeben ist, wobei die Umhüllungslage (10) bevorzugt wasserfest, besonders bevorzugt waschfest, ausgebildet ist.

## Claims

1. A method for producing an electrical contact between multiple first fibres (2) and multiple second fibres (4) by means of a connection device that features multiple electrically conductive elements (6), the method comprising the following steps:
A. positioning a first fibre (2) on an electrically conductive element (6),
B. positioning a second fibre (4) on the electrically conductive element (6) so that an electrical contact between the first fibre (2) and the second fibre (4) is established, and
C. fixing the first fibre (2) and the second fibre (4) to the connection device,
**characterised in that**
the connection device has a coating layer (10) that is folded and/or folded over in such a way that it completely surrounds the electrically conductive element (6) and that is made of a waterproof material or comprises a layer made of waterproof material.

2. The method according to claim 1, **characterised in that** the fixing is achieved by sewing, glueing or welding, the connection device preferably having a fixing layer made of a fixing material, especially a thermoplastic, that is melted, or at least softened, by heating, particularly ironing, and that cures upon cooling.

3. The method according to claim 1 or 2, **characterised in that** the first fibres (2) and the second fibres (4) are textile fibres or threads, carbon fibres or metal wires.

4. The method according to one of the preceding claims, **characterised in that** the first fibres (2) and/or the second fibres (4) each constitute part of a textile, especially a fleece, a knitted fabric or a woven fabric.

5. The method according to one of the preceding claims, **characterised in that** the coating layer (10) prior to the fixing is folded and/or folded over in such a way that it completely surrounds the electrically conductive element (6).

6. The method according to one of the preceding claims, **characterised in that** two, three, four or five first fibres (2) are connected to two, three, four or five second fibres (4), the first fibres (2) and/or the second fibres (4) preferably being connected to each other via spacers.

7. A method for connecting a first textile element (12), which has multiple first fibres (2), to a second textile element (14), which has multiple second fibres (4), by means of a connection device that features at least one electrically conductive element (6), the method comprising the following steps:
A. connecting the first fibres (2) to the second fibres (4) according to a method according to one of the preceding claims,
B. connecting the first textile element (12) to the second textile element (14), particularly by sewing.

8. The method according to claim 7, **characterised in that** the textile elements (12, 14) are first connected to each other before the fibres (2, 4) are connected.

9. The method according to claim 7 or 8, **characterised in that** the connection device is attached to the first textile element (12) and the first fibres (2) are connected to the electrically conductive element (6).

10. The method according to one of the claims 7 to 9, **characterised in that** an electrical consumer and/or an electrical energy source is arranged on the first textile element (12) and/or the second textile element (14), said consumer or energy source being completely surrounded by the coating layer (10), the coating layer (10) preferably being waterproof, especially preferably wash-resistant.

## Revendications

1. Procédé pour établir un contact électrique entre une pluralité de premières fibres (2) et une pluralité de deuxièmes fibres (4) au moyen d'un dispositif de liaison comprenant une pluralité d'éléments électriquement conducteurs (6), le procédé comprenant les étapes suivantes consistant à :
A. positionner une première fibre (2) sur un élément électriquement conducteur (6),
B. positionner une deuxième fibre (4) sur l'élément électriquement conducteur (6), de manière à établir un contact électrique entre la première fibre (2) et la deuxième fibre (4), et
C. fixer la première fibre (2) et la deuxième fibre (4) au dispositif de liaison,
**caractérisé en ce que**
le dispositif de liaison comprend une couche enveloppe (10) qui est pliée et/ou rabattue de manière à entourer complètement l'élément électriquement conducteur (6) et qui est réalisée en un matériau résistant à l'eau ou comprend une couche d'un matériau résistant à l'eau.

2. Procédé selon la revendication 1,
**caractérisé en ce que** la fixation est réalisée par couture, par collage ou par soudage, le dispositif de liaison comprenant de préférence une couche de fixation en un matériau de fixation, en particulier thermoplastique, qui est fondue ou au moins ramollie par chauffage, en particulier par repassage, et qui durcit après refroidissement.

3. Procédé selon la revendication 1 ou 2,
**caractérisé en ce que** les premières fibres (2) et les deuxièmes fibres (4) sont des fibres ou des fils textiles, des fibres de carbone ou des fils métalliques.

4. Procédé selon l'une des revendications précédentes,
**caractérisé en ce que** les premières fibres (2) et/ou les deuxièmes fibres (4) font chacune partie d'un textile, en particulier d'un non-tissé, d'un tricot ou d'un tissu.

5. Procédé selon l'une des revendications précédentes,
**caractérisé en ce qu'**avant la fixation, la couche enveloppe (10) est pliée et/ou rabattue de manière à entourer complètement l'élément électriquement conducteur (6).

6. Procédé selon l'une des revendications précédentes,
**caractérisé en ce que** deux, trois, quatre ou cinq premières fibres (2) sont reliées à deux, trois, quatre ou cinq deuxièmes fibres (4), les premières fibres (2) et/ou les deuxièmes fibres (4) étant de préférence reliées entre elles par des écarteurs.

7. Procédé de liaison d'un premier élément textile (12) comprenant une pluralité de premières fibres (2) à un deuxième élément textile (14) comprenant une pluralité de deuxièmes fibres (4) au moyen d'un dispositif de liaison comprenant au moins un élément électriquement conducteur (6), le procédé comprenant les étapes suivantes consistant à :
A. relier les premières fibres (2) aux deuxièmes fibres (4) par un procédé selon l'une des revendications précédentes,
B. relier le premier élément textile (12) au deuxième élément textile (14), en particulier par couture.

8. Procédé selon la revendication 7,
**caractérisé en ce que** les éléments textiles (12, 14) sont d'abord reliés entre eux avant que les fibres (2, 4) ne soient reliées.

9. Procédé selon la revendication 7 ou 8,
**caractérisé en ce que** le dispositif de liaison est fixé au premier élément textile (12), et les premières fibres (2) sont reliées à l'élément électriquement conducteur (6).

10. Procédé selon l'une des revendications 7 à 9,
**caractérisé en ce qu'**un consommateur électrique et/ou une source d'énergie électrique est disposé(e) sur le premier élément textile (12) et/ou sur le deuxième élément textile (14), qui est complètement entouré(e) par la couche enveloppe (10), la couche enveloppe (10) étant de préférence résistante à l'eau, de manière particulièrement préférée résistante au lavage.
